Europäisches Patentamt

European Patent Office

Office européen des brevets

(19)

(11) **EP 1 116 419 B1**

(12) **EUROPÄISCHE PATENTSCHRIFT**

(45) Veröffentlichungstag und Bekanntmachung des Hinweises auf die Patenterteilung:
**06.10.2004 Patentblatt 2004/41**

(51) Int Cl.⁷: $H05B\ 33/14$, $H01L\ 33/00$, $C09K\ 11/80$, $C09K\ 11/78$

(21) Anmeldenummer: **00960304.4**

(22) Anmeldetag: **24.07.2000**

(86) Internationale Anmeldenummer:
**PCT/DE2000/002405**

(87) Internationale Veröffentlichungsnummer:
**WO 2001/008453 (01.02.2001 Gazette 2001/05)**

(54) **LEUCHTSTOFFANORDNUNG WELLENLÄNGENKONVERTIERENDE VERGUSSMASSE UND LICHTQUELLE**

LUMINESCENT ARRAY, WAVELENGTH-CONVERTING SEALING MATERIAL AND LIGHT SOURCE

DISPOSITIF A SUBSTANCE LUMINESCENTE, MASSE DE SCELLEMENT DE CONVERSION DE LONGUEUR D'ONDE ET SOURCE LUMINEUSE

(84) Benannte Vertragsstaaten:
**AT BE CH CY DE DK ES FI FR GB GR IE IT LI LU MC NL PT SE**

(30) Priorität: **23.07.1999 DE 19934126**
**30.12.1999 DE 19963791**

(43) Veröffentlichungstag der Anmeldung:
**18.07.2001 Patentblatt 2001/29**

(60) Teilanmeldung:
**04018028.3**

(73) Patentinhaber:
• **Osram Opto Semiconductors GmbH**
**93049 Regensburg (DE)**
• **Patent-Treuhand-Gesellschaft für elektrische Glühlampen mbH**
**81543 München (DE)**

(72) Erfinder:
• **DEBRAY, Alexandra**
**D-92318 Neumarkt (DE)**

• **WAITL, Günter**
**D-93049 Regensburg (DE)**
• **KUMMER, Franz**
**D-80797 München (DE)**
• **ZWASCHKA, Franz**
**D-85737 Ismaning (DE)**
• **ELLENS, Andries**
**D-81735 München (DE)**

(74) Vertreter: **Epping Hermann & Fischer**
**Ridlerstrasse 55**
**80339 München (DE)**

(56) Entgegenhaltungen:
**EP-A- 0 142 931        GB-A- 2 000 173**

• **DATABASE WPI Section Ch, Week 200046 Derwent Publications Ltd., London, GB; Class L03, AN 2000-506318 XP002150848 & CN 1 254 747 A (CHANGCHUN PHYSICS INST CHINESE ACAD SCI), 31. Mai 2000 (2000-05-31)**

**Beschreibung**

Die Erfindung betrifft eine Lichtquellenanordnung gemäß dem Oberbegriff des Patentanspruchs 1.

Sie bezieht sich insbesondere auf eine gelb oder gelbgrün emittierende Granat-Leuchtstoffanordnung für die Anregung durch Wellenlängen im blauen oder im nahen UV-Spektralbereich. Als Vergußmasse ist insbesondere eine die Leuchtstoffanordnung enthaltende Gießharzmatrix und als Lichtquelle ist insbesondere eine lichtemittierende Diode (LED) in Verbindung mit der Leuchtstoffanordnung bzw. mit der Vergußmasse vorgesehen.

Aus der WO 98/05078 ist ein Leuchtstoff für Lichtquellen und eine zugehörige Lichtquelle bekannt. Als Leuchtstoff ist dort ein Granat mit der Struktur $A_3B_5O_{12}$:D eingesetzt, bei dem die erste Komponente aus mindestens einer von verschiedenen Seltenerdmetallen besteht, die Komponente B aus einem der Elemente Al, Ga oder In. Dotierstoff D ist Cer (Ce).

Aus der WO 97/50132 ist ein ähnlicher Leuchtstoff bekannt, bei dem als Dotierstoff entweder Ce oder Terbium (Tb) eingesetzt wird. Ce emittiert im gelben Spektralbereich, während Tb im grünen Spektralbereich emittiert. In beiden Fällen werden die Leuchtstoffe in Verbindung mit einer blau emittierenden Lichtquelle zu Erzielung einer weißen Mischfarbe verwendet.

Aus der WO 98/12757 ist eine wellenlängenkonvertierende Vergußmasse auf der Basis eines aus den vorgenannten Veröffentlichungen bekannten Leuchtstoffes und einer transparenten Vergußmatrix bekannt.

In der EP-A-0 142 931 ist ein Granat in Form eines Einkristalls mit der Struktur $A_3B_5O_{12}$:D für die Verwendung in einem Display mit Anregung durch UV-Strahlung oder Elektronenbeschuß vorgesehen. Die erste Komponente A besteht aus mindestens einer von verschiedenen Seltenerdmetallen, die Komponente B aus u.a. einem der Elemente Al, Ga oder In. Dotierstoff D ist hierbei sowohl Ce als auch Tb, wobei Ce als Aktivator und Tb als sogenannter Sensitizer dient. Tb ist in diesem Zusammenhang ein Dotierstoff, der Energie von einem Erreger absorbiert und einen Teil dieser Energie an den Aktivator abgibt, wobei etwaige wieder zurücktransferierte Energie relativ klein ist.

Bei der Erzeugung von weißem Mischlicht, beispielsweise nach der WO 97/50132, in der eine Zusammensetzung eines Vergusses und dessen Herstellung offenbart ist, ist es bekannt, die Farbtemperatur oder den Farbort des weißen Lichts durch geeignete Wahl, dh. Zusammensetzung des Leuchtstoffes, dessen Partikelgröße und dessen Konzentration zu variieren. Eine Optimierung des Farbtons (Farbort X und Y in der CIE-Farbtafel) des erzeugten weißen Lichts kann bei Zugrundelegung dieser Parameter jedoch nur mit vergleichsweise großem Aufwand optimiert werden. Dies gilt insbesondere für den sogenannten Unbuntpunkt oder "equal energy point", der bei den Koordinaten CIEX = 0,33 und CIEY = 0,33 liegt.

Weiterhin ist es aufwendig, den Leuchtstoff im Hinblick auf eine bessere Farbwiedergabe durch einen höheren Rotanteil im Spektrum zu optimieren.

Schließlich ist es schwierig, den Leuchtstoff hinsichtlich des Absorptionsmaximums des Leuchtstoffs bezogen auf den Spitzenwert der Emission des Lichtemitters hin zu optimieren.

Es ist demgemäß Aufgabe der vorliegenden Erfindung, eine Leuchtstoffanordnung der eingangs genannten Art anzugeben, der sich schnell und einfach unter Zugrundelegung von Optimierungsparametern herstellen läßt und für eine zugehörige wellenlängenkonvertierende Vergußmasse sowie eine zugehörige Lichtquelle geeignet ist.

Die Erfindung löst diese Aufgabe durch die Merkmale des Patentanspruchs 1. Vorteilhafte Weiterbildungen und Ausgestaltungen der Erfindung sind in den abhängigen Ansprüchen angegeben.

Erfindungsgemäß wird, besonders bevorzugt für Lichtquellen, deren Emission im kurzwelligen optischen, insbesondere im blauen Spektralbereich oder im nahen UV-Spektralbereich liegen, eine Leuchtstoffanordnung mit mehreren Leuchtstoffen verwendet. Diese Leuchtstoffe besitzen vorzugsweise eine mit Cer dotierte Granatstruktur $A_3B_5O_{12}$, wobei die erste Komponente A wenigstens ein Element der aus Y, Lu, Sc, La, Gd, Sm und Tb bestehenden Gruppe enthält und die zweite Komponente B mindestens eines der Elemente Aluminium, Gallium oder Indium repräsentiert.

Die Herstellung und Wirkungsweise der beschriebenen Leuchtstoffe ist in den eingangs genannten Veröffentlichungen beschrieben. Hierbei ist insbesondere bemerkenswert, daß Terbium (Tb) bei einer Anregung im Spektralbereich zwischen etwa 400 und 500 nm als Bestandteil des Wirtsgitters, das heißt der ersten Komponente A des Granats, für einen gelb emittierenden Leuchtstoff geeignet ist, dessen Dotierstoff Cer ist. Terbium war zuvor neben Cer als Aktivator für die Emission im grünen Spektralbereich vorgeschlagen worden. Es ist möglich, Terbium als Hauptbestandteil der ersten Komponente A des Granats allein oder zusammen mit mindestens einem der weiteren oben vorgeschlagenen Seltenerdmetalle zu verwenden.

Besonders bevorzugt wird ein Granat der Struktur $(Tb_{1-x-y}SE_xCe_y)_3(Al, Ga)_5O_{12}$ verwendet, wobei

$$SE = Y, Gd, La, Sm \text{ und/oder } Lu;$$

$$0 <= x <= 0{,}5-y;$$

$$0 < y < 0{,}1 \text{ gilt.}$$

Als zweite Komponente (B) wird mindestens eines der Elemente Al oder Ga verwendet. Die zweite Komponente B kann zusätzlich In enthalten. Der Aktivator ist Cer.

Diese Leuchtstoffe absorbieren elektromagnetische Strahlung mit einer Wellenlänge im Bereich zwischen 420nm bis 490nm und können deshalb für die Strahlung einer blauen Lichtquelle, insbesondere einer Halbleiter-LED, angeregt werden. LED-Halbleiterchips auf GaN-Basis oder auf InGaN-Basis sind vorzugsweise geeignet, die bei einem Emissionsmaximum im Bereich von 430 bis 480nm blaues Licht emittieren.

Unter Lumineszenzdiodenchip auf GaN- oder InGaN-Basis ist im Zusammenhang mit der vorliegenden Erfindung grundsätzlich ein Lumineszenzdiodenchip zu verstehen, dessen strahlungsemittierende Zone GaN, InGaN und/oder verwandte Nitride sowie darauf basierende Mischkristalle, wie beispielsweise Ga(Al,In)N, aufweist.

Derartige Lumineszenzdiodenchips sind beispielsweise aus Shuji Nakamura, Gerhard Fasol, The Blue Laser Diode, Springer Verlag Berlin Heidelberg 1997, S. 209ff bekannt.

Die zuvor beschriebenen Leuchtstoffe werden durch das blaue Licht angeregt und emittieren ihrerseits Licht, das wellenlängenverschoben im Bereich oberhalb 500nm liegt. Im Fall des Cer aktivierten Tb-Granat-Leuchtstoffs liegt das Maximum der Emission bei etwa 550nm.

Der oben angegebene Leuchtstoff absorbiert im Bereich 420 bis 490 nm und kann so durch die Strahlung einer blauen Lichtquelle angeregt werden. Gute Ergebnisse wurden mit einem blaues Licht emittierenden LED-Chip erzielt, dessen Emissionsmaximum bei 430 bis 470 nm liegt. Das Maximum der Emission des Tb-Granat:Ce-Leuchtstoffs liegt bei etwa 550 nm.

Dieser Leuchtstoff eignet sich besonders für die Verwendung in einem weißes Licht abstrahlenden LED-Bauelement, beruhend auf der Kombination eines blaues Licht aussendenden LED-Chips mit einem Leuchtstoffgemisch, das Tb-Granat-haltigen Leuchtstoff aufweist, der durch Absorption eines Teils der Emission des LED-Chips angeregt wird und dessen Emission die übrig bleibende Strahlung der LED zu weißem Licht ergänzt.

Als blaues Licht emittierender LED-Chip eignet sich insbesondere ein Ga(In)N-LED-Chip, aber auch jeder andere Weg zur Erzeugung einer blauen LED mit einer Emission im Bereich 420 bis 490 nm. Insbesondere wird als hauptsächlicher Emissionsbereich 430 bis 470 nm empfohlen, da dann die Effizienz am höchsten ist.

Durch die Wahl von Art und Menge an Seltenerdmetallen ist eine Feineinstellung der Lage der Absorptions- und der Emissionsbanden des Leuchtstoffgemischs möglich. In Verbindung mit Leuchtdioden eignet sich bei dem oben genannten Tb-Granat-Leuchtstoff vor allem ein Bereich für x, der zwischen $0,25 \leq x \leq 0,5\text{-}y$ liegt.

Der besonders bevorzugte Bereich von y liegt bei $0,02 < y < 0,06$.

Gute Eignung als Leuchtstoff-Komponente zeigt ein Granat der Struktur $(Tb_xSE_{1\text{-}x\text{-}y}Ce_y)_3(Al,Ga)_5O_{12}$, wobei SE = Y, Gd, La und/oder Lu; $0 < x \leq 0,02$, insbesondere x = 0,01; $0 < y < 0,1$ gilt. Häufig liegt y im Bereich 0,01 bis 0,05.

Generell dienen kleinere Mengen an Tb im Wirtsgitter vor allem dazu, die Eigenschaften bekannter Cer-aktivierter Leuchtstoffe zu verbessern, während die Zugabe größerer Mengen an Tb gezielt vor allem dafür eingesetzt werden kann, die Wellenlänge der Emission bekannter Cer-aktivierter Leuchtstoffe zu verschieben. Daher eignet sich ein hoher Anteil Tb besonders gut für weiße LED mit niedriger Farbtemperatur unter 5000 K.

Es ist bekannt, blau emittierende LEDs auf Gallium-Nitridoder Indium-Gallium-Nidtrid-Basis mit Emissionsmaxima im Bereich zwischen 430 und 480nm zur Anregung eines Leuchtstoffs von Typ YAG:Ce, der in der Literatur ausführlich beschrieben ist, zu verwenden. Ein derartiger Leuchtstoff wird beispielsweise von der Firma Osram unter der Bezeichnung L175 vertrieben. Andere Leuchtstoffe sind bekannt, bei denen das Elemente Yttrium (Y) teilweise oder vollständig durch eines der oben angegebenen Seltenerdmetalle ersetzt ist.

Bei einem für das erfindungsgemäße Leuchtstoff-Gemisch geeigneten Leuchtstoff sind die Yttrium-Atome größtenteils durch Terbium ersetzt sind. Der Leuchtstoff kann beispielsweise die Zusammensetzung $[Y_{0,29}Tb_{0,67}Ce_{0,04}]_3Al_5O_5$ - nachfolgend als L175/Tb mit 67% Tb bezeichnet - haben.

Erfindungsgemäß ist vorgesehen, den Farbton und Farbort der Leuchtstoffanordnung durch Mischen von pigmentierten Leuchtstoffpulvern mit unterschiedlichen Zusammensetzungen und damit auch unterschiedlichen Absorptionsmaxima für das blaue Licht vorzusehen. Dies kann beispielsweise durch eine Mischung des Leuchtstoffs L175 (reines YAG:Ce) mit einem Leuchtstoff der beschriebenen Art, bei dem Yttrium teilweise oder vollständig durch Terbium ersetzt ist (L175/Tb,Tb > 0%), erfolgen. Das Mischungsverhältnis kann 1:1 sein. Es kann an Stelle von YAG:Ce jedoch auch ein anderer Leuchtstoff oder ein anderer aus diesem Leuchtstoff abgewandelter Leuchtstoff verwendet werden, wobei zusätzlich das Mischungsverhältnis variiert werden kann.

Ein besonderer Vorteil der Erfindung liegt darin, daß sich die Leuchtstoffe, die in Pulverform vorliegen, problemlos mischen lassen und damit auf vergleichsweise einfache Weise eine gezielte Einstellung des Zielfarbortes auf der CIE-Farbtafel ermöglichen. Auf der Farbtafel läßt sich somit ausgehend von einer Granatstruktur, wie reinem YAG:Ce, und dem Farbort der verwendeten LED ein Bündel von Geraden darstellen, von denen eine durch die ausgewählte Koordinate des Zielfarbortes geht. Durch die Kombination von LED-Chip und Leuchtstoffanordnung läßt sich die resultierende Farbortgerade der einzelnen Farborte in ihrer Neigung leicht variieren. So ist es ohne weiteres möglich, eine Lichtquellenanordnung mit einer LED und einem wellenlängenkonvertierenden Leuchtstoff zu erzeugen, dessen resultierende Farbortgerade exakt durch den Unbuntpunkt bei den Koordinaten X=0,33 und Y=0,33 auf der Farborttafel geht. Dieser Unbuntpunkt definiert reines Weiß. Darüber hinaus ist es möglich, eine Verschiebung des resultierenden Farbspektrums zu erreichen, beispielsweise hin zu einem höheren Rotanteil im Spektrum, was allgemein zu einer besseren Farbwiedergabe führt, beispielsweise durch höhere L175/Tb-Anteile.

Erfindungsgemäß ist weiterhin vorgesehen, eine Leuchtstoffanordnung gemäß der Erfindung in einer für die erzeugte Strahlung zumindest teilweise transparenten Vergußmasse, vorzugsweise in einem Kunststoff, besonders bevorzugt in einem Epoxid-, Silikon- oder Acrylat-Gießharz oder in einer Mischung solcher Harze, oder in einem anderen geeigneten strahlungsdurchlässigen Material, wie zum Beispiel anorganisches Glas, zu dispergieren. Dazu wird die erfindungsgemäße Leuchtstoffanordnung vorzugsweise als Pigmentpulvergemisch mit dem Gießharz und weiteren Elementen gemäß der in der WO98/12757 offenbarten Methode hergestellt.

Weiterhin ist gemäß der Erfindung eine zur Leuchtstoffanordnung gehörige Lichtquellenanordnung vorgesehen, bei der eine Strahlungsquelle Strahlung im blauen Bereich oder im UV-Bereich des optischen Spektrums emittiert und diese Strahlung teilweise oder vollständig mittels der erfindungsgemäßen Leuchtstoffanordnung in längerwellige Strahlung konvertiert wird, wobei bei teilweiser Konversion die konvertierte Strahlung mit der emittierten Strahlung der Strahlungsquelle zur Erzeugung weissen Mischlichts gemischt wird.

Eine derartige Lichtquellenanordnung mit allerdings nur einem Leuchtstoff ist ebenfalls aus der WO98/12757 bekannt.

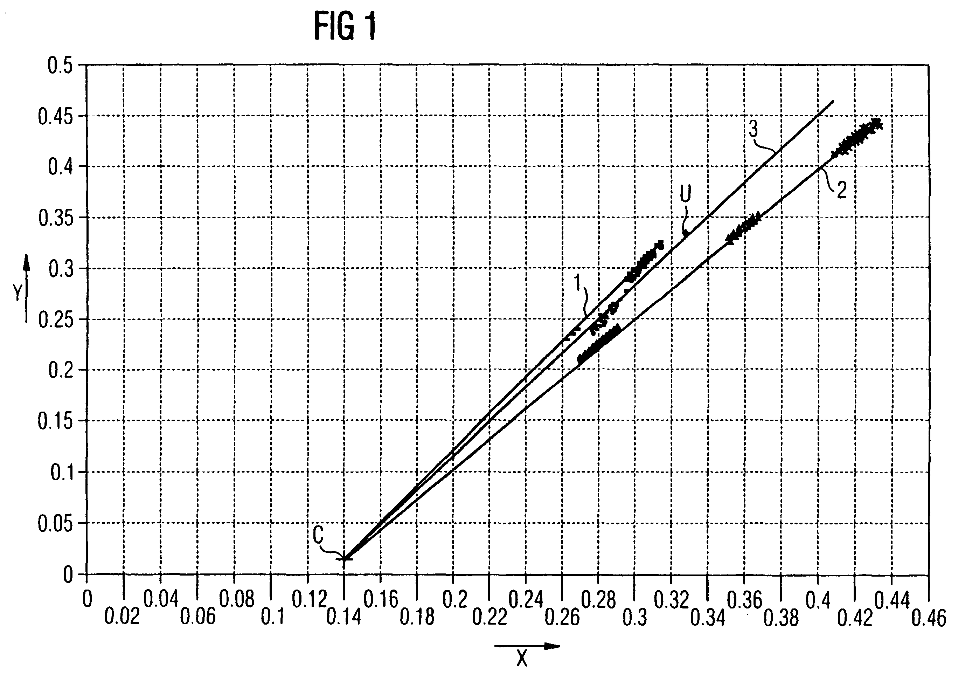

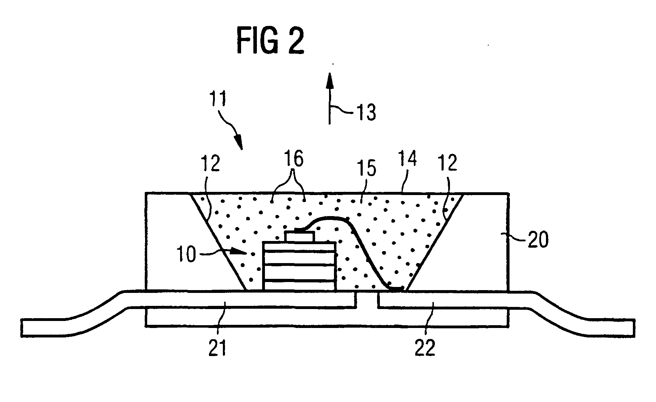

Die Erfindung wird nachfolgend anhand eines Ausführungsbeispieles in Verbindung mit den Figuren 1 und 2 der Zeichnung näher beschrieben. Es zeigen:

Figur 1    ein Farbortdiagramm mit Farbortgeraden unterschiedlicher Leuchtstoffe und der erfindungsgemäßen Leuchtstoffanordnung und

Figur 2    eine schematische Schnittdarstellung durch das Ausführungsbeispiel einer Lichtquellenanordnung gemäß der Erfindung.

Gemäß der Figur 1 ist ein Farbortdiagramm dargestellt, das auf der Abszisse die Farbortkoordinate X und auf der Ordinate die Farbortkoordinate Y der CIE-Farbtafel enthält.

Zugrundegelegt ist eine Lichtquellenanordnung zur Erzeugung weißen Mischlichts, wie sie beispielsweise in der WO97/50132 beschrieben ist.

Verwendet wird beispielsweise ein InGaN-basierter LED-Chip, der im blauen Spektralbereich emittiert und dessen Farbortpunkt C dementsprechend im Farbortdiagramm etwa bei X=0,14 und Y=0,02 liegt. Bei Mischung des blauen Lichts der LED mit dem Farbort C und des emittierten Lichtes eines beispielsweise in einem transparenten Gießharz eingebetteten Leuchtstoffes ergeben sich unterschiedliche Farbortgeraden.

Beispielsweise ergibt sich bei Verwendung von reinem YAG:Ce als Leuchtstoff eine Farbortgerade 1. Bei Verwendung eines Leuchtstoffs, bei dem Y teilweise oder überwiegend durch Terbium ersetzt ist, ergibt sich eine Farbortgerade, die unterhalb der Farbortgeraden 1 verläuft. Unter Verwendung eines Leuchtstoffes mit Tb-Gehalt auf dem A-Platz von 67% (gemäß der weiter oben angegebenen Formel), ergibt sich die im Diagramm eingezeichnete Farbortgerade 2.

Gerade 1 läuft oberhalb und Gerade 2 läuft unterhalb des Unbuntpunktes U, der bei den Farbortkoordinaten X=0,33 und Y=0,33 liegt. Bei einer Mischung der beiden Leuchtstoffe mit den Farbgeraden 1 und 2 im Verhältnis 1:1 und einer Einbettung in transparentes Gießharz (man vergleiche das weiter unten offenbarte Ausführungsbeispiel gemäß Figur 2) ergibt sich eine Farbortgerade 3 die, wie das Diagramm von Figur 1 zeigt, exakt durch den Unbuntpunkt oder Weißpunkt der Farborttafel geht.

In ähnlicher Weise ist es möglich, durch eine Mischung unterschiedlicher Leuchtstoffe vorzugsweise mit einer Granatstruktur, Farbortkurven durch verschiedene gewünschte Koordinaten der CIE-Farbtafel zu erhalten.

Das Leuchtstoffpulvergemisch ist vorteilhafterweise in ein entsprechend optimiertes Gießharz eingebettet, wobei insbesondere die Korngrößen des Leuchtstoffpulvers optimiert werden können. Verfahren zur Herstellung derartiger wellenkonvertierender Vergußmassen sind in der WO98/1275 beschrieben.

Bei der in Figur 2 schematisch dargestellten besonders bevorzugten Ausführungsform einer Lichtquellenanordnung ist ein GaN- oder InGaN-basierter Leuchtdiodenchip 10 in einer Ausnehmung 11 eines strahlungsundurchlässigen Leuchtdioden-Grundgehäuses 20, das vorzugsweise aus Kunststoff besteht, angeordnet.

Das Leuchtdioden-Grundgehäuse 20 ist von elektrischen Anschlußbahnen oder -beinchen 21,22 durchdrungen, über die die elektrischen Anschlüsse des Chips 10 aus dem Gehäuse herausgeführt sind.

Die Innenwände 12 der Ausnehmung 11 bilden einen Reflektor für das von dem Chip 10 ausgesandte Licht und für das von dem Leuchtstoffgemisch emittierte Licht und lenken dieses zur Hauptabstrahlrichtung 13 des Chips 10 hin um.

Die Ausnehmung 11 ist mit einer Vergussmasse 14 gefüllt, die eine transparente Gießharzmatrix 15, bevorzugt Epoxidgießharz oder Acrylatharz (z.B. Poymethylmetacrylat) oder eine Mischung dieser Harze aufweist, in die das vorgesehene Leuchtstoffpulvergemisch 16 eingebettet ist.

Das Leuchtstoffpulvergemisch enthält vorzugsweise Leuchtstoffpigmente mit Korngrößen $\leq$ 20μm und einen mittleren Korndurchmesser $d_{50} \leq 5$μm.

Neben Gießharz 15 und Leuchtstoffpigmenten 16 sind in der Vergußmasse 14 weiterhin vorzugsweise ein Thixotropiermittel, ein mineralischer Diffusor, ein Hydrophobiermittel und/oder ein Haftvermittler enthalten.

Bei dem Ausführungsbeispiel handelt es sich beispielsweise um ein weisses Licht emittierendes Leuchtdioden-Bauelement, bei dem in der Vergußmasse 14 die Farbstoffpulver L175 (YAG:Ce) und L175/Tb (mit 67% Tb) mit einem Mischungsverhältnis von 1:1 enthalten sind und dessen Farbort des emittierten Mischlichts auf der Geraden 3 des in Figur 1 dargestellten Diagramms liegt.

Es versteht sich, daß die Erläuterung der Erfindung anhand des oben beschriebenen Ausführungsbeispiels natürlich nicht als Beschränkung der Erfindung auf die beschriebenen Merkmale selbst anzusehen ist. Als Lichtquelle kommen neben Halbleiterkörpern aus Leuchtdioden-Chips oder Laserdioden-Chips insinsbesondere auch Polymer-LEDs in Betracht. Ebenso fallen in den Bereich der Erfindung auch Leuchtstoffpulver, die neben reinem YAG:Ce auch Anteile von Lu, Sc, La, Gd sowie Sm anstelle von Y besitzen. Weiterhin sind Granate einbezogen, bei denen der Terbium-Anteil kleiner ist als bei der oben beschriebenen Leuchtstofformel.

Die erfindungsgemäße Leuchtstoffanordnung und die zugehörige Vergußmasse ist grundsätzlich bei allen in der WO97/5013 und in der WO98/12757 offenbarten Bauformen von Leuchtdioden-Bauelementen verwendbar.

**Patentansprüche**

1. Lichtquellenanordnung mit einer Strahlungsquelle, die Strahlung des Wellenlängenbereichs zwischen 400 nm und 500 nm, insbesondere zwischen 430 nm und 480 nm emittiert, wobei diese Strahlung teilweise oder vollständig mittels einer Leuchtstoffanordnung mit mehreren Leuchtstoffen in längerwellige Strahlung konvertiert wird und bei teilweiser Konversion konvertierte Strahlung mit emittierter Strahlung der Strahlungsquelle gemischt wird, **dadurch gekennzeichnet,** **daß** die Leuchtstoffanordnung mindestens einen Leuchtstoff mit einer mit Ce aktivierten Granatstruktur $A_3B_5O_{12}$ aufweist, bei der

   - die erste Komponente A wenigstens ein Element der aus Y, Lu, Sc, La, Gd, Sm und Tb bestehenden Gruppe enthält und zumindest teilweise durch Tb als Bestandteil des Wirtsgitters besetzt ist, und
   - die zweite Komponente B mindestens eines der Elemente Al, Ga oder In enthält.

2. Lichtquellenanordnung nach Anspruch 1, **dadurch gekennzeichnet**, bei der die Leuchtstoffanordnung mindestens einen weiteren Leuchtstoff mit einer mit Ce aktivierten Granatstruktur $A_3B_5O_{12}$ aufweist, bei der

   - die erste Komponente A wenigstens ein Element der aus Y, Lu, Sc, La, Gd und Sm bestehenden Gruppe enthält und
   - die zweite Komponente B mindestens eines der Elemente Al, Ga oder In enthält.

3. Lichtquellenanordnung nach Anspruch 1 oder 2, **dadurch gekennzeichnet,** **daß** als Strahlungsquelle eine blaues Licht emittierende Leuchtdiode verwendet ist.

4. Lichtquellenanordnung nach einem der Ansprüche 1 bis 3, **dadurch gekennzeichnet,** **daß** als Strahlungsquelle eine Leuchtdiode auf GaN- oder InGaN-Basis verwendet ist.

5. Lichtquellenanordnung nach einem der Ansprüche 1 bis 4, **dadurch gekennzeichnet,** **daß** die Mischung der Leuchtstoffe einen Granat der Struktur $Y_3(Al, Ga)_5O_{12}$:Ce und einen Granat der Struktur $(Tb_{1-x-y} SE_xCe_y)_3(Al,Ga)_5O_{12}$ enthält, wobei SE = Y, Gd, La und oder Lu; $0 \leq x \leq 0,5$-y; $0 < y < 0,1$ gilt.

6. Lichtquellenanordnung nach einem der Ansprüche 1 bis 5, **dadurch gekennzeichnet,** **daß** sie eine wellenlängenkonvertierende Vergußmasse auf der Basis eines transparenten Kunststoffes, insbesondere eines Gießharzes aufweist und daß die Leuchtstoffanordnung als anorganisches Leuchtstoffpigmentpulvergemisch im transparenten Kunststoff dispergiert ist.

7. Lichtquellenanordnung nach Anspruch 6, **dadurch gekennzeichnet,** **daß** die Leuchtstoffpigmente Korngrößen $\leq 20$μm und einen mittleren Korndurchmesser $d_{50} \leq 5$μm aufweisen.

8. Lichtquellenanordnung nach Anspruch 6 oder 7, **dadurch gekennzeichnet,** **daß** neben Gießharz und Leuchtstoffpigmenten weiterhin Thixotropiermittel, ein mineralischer Diffusor, ein Hydrophobiermittel und/oder ein Haftvermittler enthalten sind.

9. Lichtquellenanordnung nach einem der Ansprüche 1 bis 8,
**dadurch gekennzeichnet,**
**daß** die Leuchtstoffanordnung durch eine Strahlung des Wellenlängenbereichs zwischen 400 nm und 500 nm, insbesondere zwischen 420 nm und 490nm anregbar ist.

10. Lichtquellenanordnung nach einem der Ansprüche 1 bis 9,
**dadurch gekennzeichnet,**
**dass** die konvertierte Strahlung und die emittierte Strahlung der Strahlungsquelle zu weißem Licht gemischt werden.

**Claims**

1. Light source arrangement having a radiation source which emits radiation from the wavelength range between 400 nm and 500 nm, in particular between 430 nm and 480 nm, this radiation being partly or completely converted into longer-wave radiation by means of a luminescent material arrangement having a plurality of luminescent materials and, in the event of partial conversion, converted radiation being mixed with emitted radiation from the radiation source,
**characterized**
**in that** the luminescent material arrangement has at least one luminescent material with a Ce-activated garnet structure $A_3B_5O_{12}$, in the case of which

   - the first component A contains at least one element of the group comprising Y, Lu, Sc, La, Gd, Sm and Tb and is at least partly occupied by Tb as constituent of the host lattice, and
   - the second component B contains at least one of the elements Al, Ga or In.

2. Light source arrangement according to Claim 1,
**characterized**
**in** which the luminescent material arrangement has at least one further luminescent material with a Ce-activated garnet structure $A_3B_5O_{12}$, in the case of which

   - the first component A contains at least one element of the group comprising Y, Lu, Sc, La, Gd and Sm, and
   - the second component B contains at least one of the elements Al, Ga or In.

3. Light source arrangement according to Claim 1 or 2,
**characterized**

**in that** a light-emitting diode that emits blue light is used as the radiation source.

4. Light source arrangement according to one of Claims 1 to 3,
**characterized**
**in that** a GaN-based or InGaN-based light-emitting diode is used as the radiation source.

5. Light source arrangement according to one of Claims 1 to 4,
**characterized**
**in that** the mixture of the luminescent materials contains a garnet having the structure $Y_3(Al, Ga)_5O_{12}$:Ce and a garnet having the structure $(Tb_{1-x-y} SE_x Ce_y)3(Al, Ga)_5O_{12}$, wherein
SE = Y, Gd, La and/or Lu;
$0 \leq x \leq 0.5-y$;
$0 < y < 0.1$ hold true.

6. Light source arrangement according to one of Claims 1 to 5,
**characterized**
**in that** it has a wavelength-converting potting compound based on a transparent plastic, in particular a casting resin, and in that the luminescent material arrangement is dispersed as an inorganic luminescent material pigment powder mixture in the transparent plastic.

7. Light source arrangement according to Claim 6,
**characterized**
**in that** the luminescent material pigments have grain sizes of $\leq 20$ μm and an average grain diameter of $d_{50} \leq 5$ μm.

8. Light source arrangement according to Claim 6 or 7,
**characterized**
**in that** thixotropic agents, a mineral diffuser, a hydrophobizing agent and/or an adhesion promoter are furthermore contained in addition to casting resin and luminescent material pigments.

9. Light source arrangement according to one of Claims 1 to 8,
**characterized**
**in that** the luminescent material arrangement can be excited by a radiation from the wavelength range between 400 nm and 500 nm, in particular between 420 nm and 490 nm.

10. Light source arrangement according to one of Claims 1 to 9,
**characterized**
**in that** the converted radiation and the emitted radiation of the radiation source are mixed to form white light.

**Revendications**

1. Dispositif formant source de lumière, comprenant une source de rayonnement qui émet du rayonnement du domaine de longueur d'onde compris entre 400 nm et 500 nm, notamment entre 430 nm et 480 nm, ce rayonnement étant transformé en tout ou partie au moyen d'un dispositif à substances luminescentes ayant plusieurs substances luminescentes en du rayonnement de plus grande longueur d'onde et, s'il y a transformation partielle du rayonnement transformé, étant mélangé à du rayonnement émis de la source de rayonnement, **caractérisé en ce que** le dispositif à substances luminescentes comprend au moins une substance luminescente ayant une structure de grenat $A_3B_5O_{12}$ activée par du Ce, dans laquelle

   - le premier constituant A comporte au moins un élément du groupe constitué de Y, Lu, Sc, La, Gd, Sm et Tb et est occupé au moins en partie par Tb en tant qu'élément constitutif du réseau hôte, et
   - le deuxième constituant B comporte au moins l'un des éléments Al, Ga ou In.

2. Dispositif formant source de lumière suivant la revendication 1, **caractérisé en ce que** le dispositif à substances luminescentes a au moins une autre substance luminescente ayant une structure de grenat $A_3B_5O_{12}$ activée par du Ce, dans laquelle

   - le premier constituant A comporte au moins un élément du groupe constitué de Y, Lu, Sc, La, Gd, Sm, et
   - le deuxième constituant B comporte au moins l'un des éléments Al, Ga ou In.

3. Dispositif formant source de lumière suivant l'une des revendications 1 ou 2, **caractérisé en ce qu'**il est utilisé comme source de rayonnement d'une diode luminescente émettant dans la lumière bleue.

4. Dispositif formant source de lumière suivant l'une des revendications 1 à 3, **caractérisé en ce qu'**il est utilisé comme source de rayonnement d'une diode luminescente à base de GaN ou à base de In-GaN.

5. Dispositif formant source de lumière suivant l'une des revendications 1 à 4, **caractérisé en ce que** le mélange des substances luminescentes comprend un grenat ayant la structure $Y_3(Al,Ga)_5O_{12}$:Ce et un grenat ayant la structure $(Tb_{1-x-y} SE_x Ce_y)_3(Al,Ga)_5O_{12}$, dans lesquelles SE = Y, Gd, La et/ou Lu ;

$0 \leq x \leq 0.5\text{-}y$ ;
$0 < y < 0,1$.

6. Dispositif formant source de lumière suivant l'une des revendications 1 à 5, **caractérisé en ce qu'**il comporte une masse de scellement transformant les longueurs d'onde et à base d'une matière plastique transparente, notamment d'une résine de coulée, et **en ce que** le dispositif à substances luminescentes est dispersé dans la matière plastique transparente sous la forme d'un mélange pulvérulent de pigments minéraux de substance luminescente.

7. Dispositif formant source de lumière suivant la revendication 6, **caractérisé en ce que** les pigments de substance luminescente ont des granulométries $\leq 20\ \mu m$ et un diamètre moyen de grain $d_{50} \leq 5\ \mu m$.

8. Dispositif formant source de lumière suivant la revendication 6 ou 7, **caractérisé en ce qu'**il est contenu, outre de la résine de coulée et du pigment de substance luminescente, un agent thixotrope, un diffuseur minéral, un agent donnant de l'hydrophobie et/ou un agent adhésif.

9. Dispositif formant source de lumière suivant l'une des revendications 1 à 8, **caractérisé en ce que** le dispositif à substances luminescentes peut être excité par un rayonnement du domaine des longueurs d'onde compris entre 400 nm et 500 nm, notamment compris entre 420 nm et 490 nm.

10 Dispositif formant source de lumière suivant l'une des revendications 1 à 9, **caractérisé en ce que** le rayonnement transformé et le rayonnement émis de la source de rayonnement sont mélangés en de la lumière blanche.

# FIG 1

EP 1 116 419 B1

# FIG 2